(19) Europäisches Patentamt
European Patent Office
Office européen des brevets

(11) **EP 0 717 494 A2**

(12) **EUROPÄISCHE PATENTANMELDUNG**

(43) Veröffentlichungstag:
19.06.1996 Patentblatt 1996/25

(51) Int. Cl.$^6$: **H03H 17/06**

(21) Anmeldenummer: 95115668.6

(22) Anmeldetag: 05.10.1995

(84) Benannte Vertragsstaaten:
AT CH ES FR GB IT LI

(30) Priorität: 13.12.1994 DE 4444203

(71) Anmelder: DORNIER GmbH
D-88039 Friedrichshafen (DE)

(72) Erfinder: Serbe, Christoph Peter, Ing.
D-88709 Hagnau (DE)

(54) **Verfahren und Vorrichtung zur digitalen Filterung**

(57) Die Erfindung betrifft ein Verfahren zur Filterung von Bandpaß-Signalen mit einer Mittenfrequenz von etwa einem Viertel der Abtastrate, mit folgenden Verfahrensschritten:

- I-Q-Mischen des Eingangssignals mit einem Viertel der Abtastrate des Eingangssignals
- Filterung und Dezimation jeweils im I- und Q-Kanal um einen Faktor n, wobei n = 2, 3 ,4, ....... ist
- I-Q-Rückmischen zur Gewinnung des Ausgangssignals mit einer Abtastrate, welche halb so groß ist wie die dezimierte Abtastrate im I- und Q- Kanal.

Fig. 1

**Beschreibung**

Die Erfindung betrifft ein Verfahren sowie eine Vorrichtung zur digitalen Filterung von bandpaßartigen Signalen mit einer Mittenfrequenz von etwa einem Viertel der Abtastfrequenz.

Die Halbierung der Abtastrate von Signalen, die wesentliche spektrale Komponenten bei einem Viertel ihrer Abtastrate haben, ist nur mit erheblichem Aufwand möglich, da Halbbandfilter nicht zur Filterung solcher Signale geeignet sind.

Halbband-Filter, die die Abtastrate um den Faktor zwei vermindern, sind grundsätzlich ein sehr effektives Mittel, um ein Nutzsignal aus einem Signalgemisch zu isolieren. Die große Effektivität dieser Filter ist in der Tatsache begründet, daß beinahe die Hälfte der Koeffizienten des Halbband-Filters den Wert Null haben. Halbband-Filter sind aber für die Dezimation von Signalen, die im mittleren Spektralbereich des digitalisierten Signalgemschs liegen, aus zwei Gründen nicht anwendbar:

- Der zentrale Spektralbereich eines Signals fällt nach der Dezimation auf sein eigenes Spiegelbild. Daher kann eine Verfälschung des Signals prinzipiell nicht vermieden werden, wenn der zu filternde Spektralbereich die genaue Mittenfrequenz des digitalisierten Signals enthält.
- Signale, die nahe an der Mittenfrequenz liegen, erfordern den Einsatz von Halbband-Filtern mit steilen Flanken. Diese Filter erfordern jedoch oft einen untragbar hohen Realisierungsaufwand.

Der konventionelle Lösungsansatz beruht auf Filtern mit komplexer Signaldarstellung. Diese Filter erfordern jedoch den Einsatz eines digitalen, numerisch gesteuerten Oszillators (NCO = Numerical Controlled Oscillator), dessen Frequenz auf die Mittenfrequenz des Nutzsignals abgestimmt ist. Der NCO dominiert oft den Realisierungsaufwand des gesamten Filters. Daher scheitert diese Methode in Situationen, in denen niedrige Leistungsaufnahme und hohe Geschwindigkeit erforderlich sind.

Aufgabe der Erfindung ist es deshalb, ein Verfahren zu schaffen, mit dem die genannten Probleme ohne den Einsatz eines NCO's überwunden werden können.

Diese Aufgabe wird mit dem Verfahren nach Anspruch 1 gelöst. Vorrichtungen zur Ausführung des Verfahrens sind Gegenstand weiterer Ansprüche.

Mit dem erfindungsgemäßen Verfahren ist es möglich, die Vorteile der Halbband-Filter für den zentralen Spektralbereich auszunutzen. Das Eingangssignal wird in seiner Frequenzlage so verschoben, daß der mittlere Spektralbereich des verschobenen Signals bei der Frequenz Null liegt. Dann kann ein einfaches Tiefpaß-Filter zur Selektion des Nutzsignals eingesetzt werden. Der Rechenaufwand des Filters sinkt drastisch. Darüber hinaus kann eine Vorrichtung zur Durchführung des Verfahrens leicht durch eine kleine Modifikation eines Standard-FIR-Filters implementiert werden (FIR= Finite Impulse Response).

Im einzelnen weist das erfindungsgemäße Verfahren folgende Verfahrensschritte auf:

- I-Q-Mischen des Eingangssignals mit einem Viertel der Abtastrate des Eingangssignals.
- Filterung und Dezimation jeweils im I- und Q-Kanal um einen Faktor n, wobei n= 2,3,4,... ist, bevorzugt ist n = 2.
- I-Q-Rückmischen zur Gewinnung des Ausgangssignals mit einer Abtastrate, welche halb so groß ist wie die dezimierte Abtastrate in I- und Q-Kanal. Dabei entsteht wieder ein reelles Signal, wobei jedoch nun die Abtastrate des Ausgangssignals nach dem I-Q-Rückmischen nur 1/n-tel der Abtastrate des Eingangssignals beträgt.

Die Erfindung wird im folgenden anhand von Fig. näher erläutert.

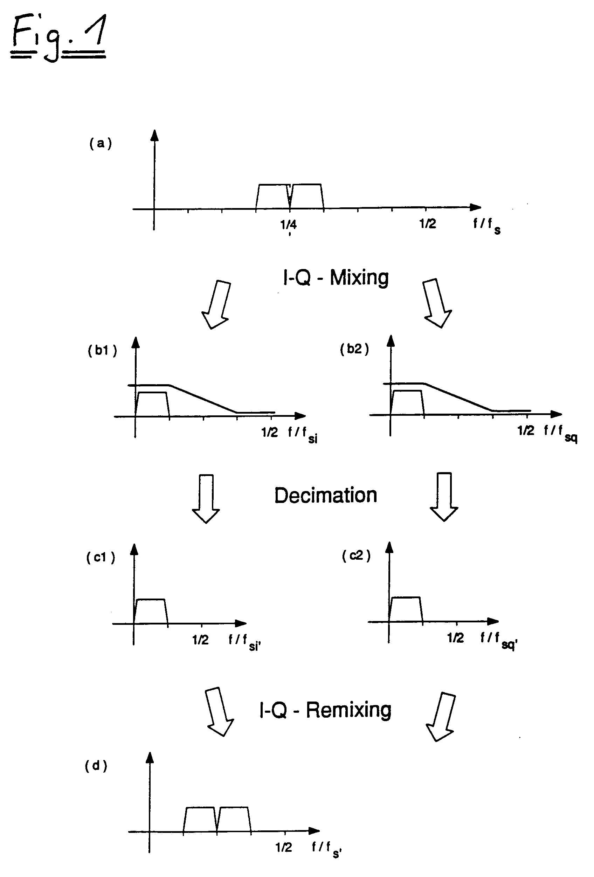

Fig. 1      erläutert die grundlegende Arbeitsweise des erfindungsgemäßen Verfahrens. Eine spektrale Komponente, die bei einem Viertel der Abtastrate liegt, soll aus dem digitalisierten Signal herausgefiltert werden (Fig. 1a). Das Verfahren läuft nun in drei Schritten ab:

- Zuerst wird das Signal in seine In-Phase und seine Quadratur-Komponente aufgeteilt. Dies wird erreicht durch I-Q-Mischen. Die Abtastrate wird durch das I-Q-Mischen halbiert. Daher ist der gesuchte Signalanteil in beiden Zweigen durch Aliasing verfälscht (Dies ist genau der Grund, aus dem die Standard-Dezimation versagt!).
- Der zweite Schritt ist eine Dezimation um den Faktor zwei. Um Aliasing in den Teilkanälen zu vermeiden, werden I- und Q-Komponente mit einem Tiefpaß-Filter gefiltert (Fig. 1b). Dieses Filter ist relativ klein, da die erforderliche Übergangsbandbreite normalerweise relativ groß ist. Die Abtastrate wird durch die Dezimation erneut halbiert (Fig. 1c).
- Der Prozeß wird abgeschlossen durch I-Q-Rückmischen (Fig. 1c). Die I- und Q-Komponenten werden zu einem reellen Signal zusammengesetzt, das mit der halben Rate des Eingangssignals abgetastet ist. Dieser Schritt stellt das Nutzsignal bei einer erniedrigten Mittenfrequenz wieder her.

In Fig. 1 bezeichnet $f_s$ die aktuelle Abtastrate des Eingangssignals. $f_{si}$ bzw $f_{sq}$ bezeichnet die Abtastrate für das I-Q-Mischen in den beiden Kanälen I und Q.

$f_{si'}$ bzw $f_{sq'}$ bezeichnet die Abtastrate für das dezimierte Signal in den beiden Kanälen I und Q.

$f_{s'}$ bezeichnet die Abtastrate des Ausgangssignals nach dem I-Q-Rückmischen.

Bei der hier vorgenommenen Dezimation um den Faktor n=2 gilt: $f_s$ =2$f_{si}$ =2$f_{sq}$ =4 $f_{si'}$ =4 $f_{sq'}$=2 $f_{s'}$.

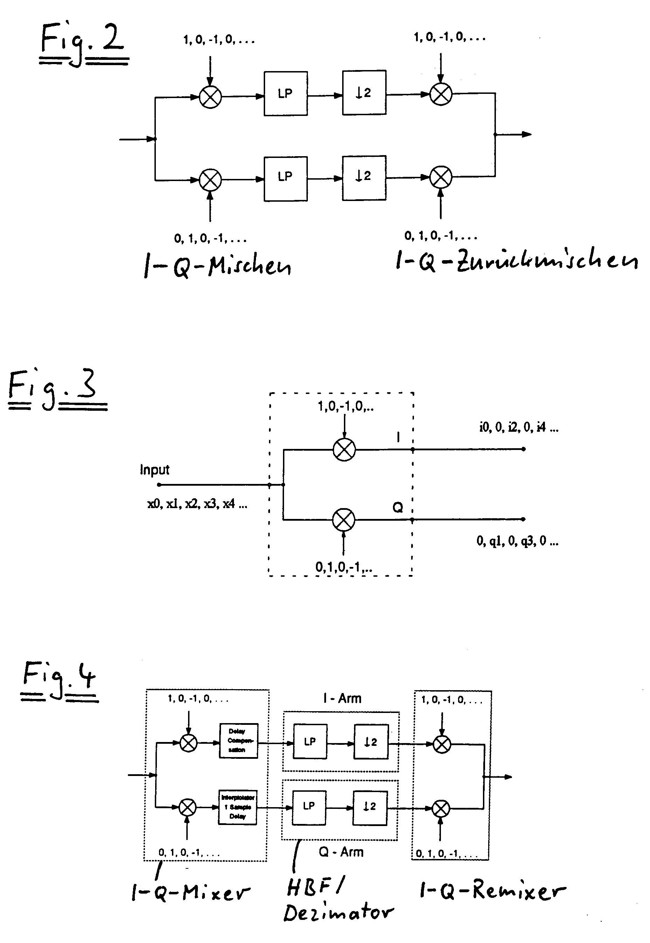

Fig. 2 zeigt die entsprechende Darstellung des erfindungsgemäßen Verfahrens im Zeitbereich. Zuerst wird das Eingangssignal in seine I- und Q-Komponente aufgeteilt. Hierbei wird eine komplexe Modulation mit dem Viertel der Abtastrate als Modulationsfrequenz verwendet. Dann bereiten Tiefpaß-Filter LP die Dezimation vor. Nach der Dezimation werden die beiden Teilsignale durch eine I-Q-Rückmischen bei einem Achtel der ursprünglichen Abtastrate wieder zusammengefügt. Daher entspricht die Folge 1,0,.... beim I-Q-Rückmischen dem Achtel der Eingangsabtastrate. Die zweite Mischstufe arbeitet also nur mit der halben Abtastrate des Eingangssignals.

Während die Dezimation und das I-Q-Rückmischen relativ einfach zu verstehen sind, wird im folgenden das I-Q-Mischens ausführlicher beschrieben. Dies insbesondere deshalb, da zwischen analoger und digitaler Realisierung, sowie zur konventioneller Multirate-Technik einige Unterschiede bestehen.

Das Eingangssignal des I-Q-Mischers $X(\omega)$ kann als Modulation eines komplexen Signals $X_c(\omega)$

$$X(\omega)= \tfrac{1}{2}\{X_c(\omega - \omega_s/4) + X_c(\omega + \omega_s/4)\} \qquad (1)$$

aufgefaßt werden. Dann können die In-Phase Komponente $I(\omega)$ und die Quadratur-Komponente $Q(\omega)$

$$X_c(\omega)= I(\omega) + jQ(\omega) \qquad (2)$$

durch Mischen des Eingangssignals mit dem Viertel der Abtastrate bestimmt werden. Dies ist sehr günstig, da die Abtastwerte von Sinus- und Kosinuswelle in Sequenzen aus Nullen und Einsen zerfallen.

$$
\begin{aligned}
\sin(\Omega_s/4 \cdot nT) &= 0,1,0,-1,\ldots & \Big|\, n=0,1,2,\ldots \\
\cos(\Omega_s/4 \cdot nT) &= 1,0,-1,0,\ldots & \Big|\, n=0,1,2,\ldots
\end{aligned}
\qquad (3)
$$

Damit sind die Abtastwerte von In-Phase- und Quadratur-Komponente i[n] und q[n] durch

$$
\begin{aligned}
q[n] &= (-1)^{\frac{n-1}{2}} \cdot x[n] & n \text{ ungerade} \\
i[n] &= (-1)^{\frac{n}{2}-1} \cdot x[n] & n \text{ gerade}
\end{aligned}
\qquad (4)
$$

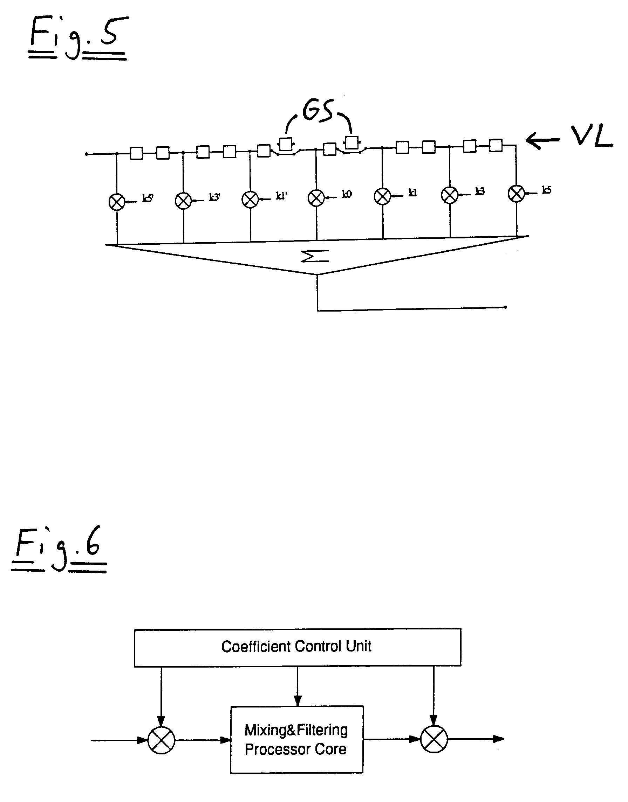

in Abhängigkeit vom Eingangssignal x[n] gegeben. Dies bedeutet, daß die Eingangsfolge $x_0$, $x_1$, $x_2$, $x_3$ ... in eine In-phase-Folge $i_0$, $i_1$, $i_2$, $i_3$ ... und eine Quadratur-Folge $q_0$, $q_1$, $q_2$, $1_3$ ... zerfällt. Die In-phase-Folge ist $x_0$, 0, - $x_2$, 0 ..., die Quadratur-Folge 0, $x_1$, 0, -$x_3$ ... . Das prinzipielle Schaubild eines solchen digitalen $f_s$ /4 -I-Q-Mischers ist in Fig. 3 dargestellt.

Es sind keine komplizierten Operationen erforderlich, um diese Folgen zu bestimmen. Trotzdem weist diese Betrachtung auf ein Problem hin: Die In-Phase Samples sind bei den geraden Abtastzeitpunkten gegeben, während die Quadratur-Samples zu ungeraden Zeitpunkten genommen wurden. Dies spielt im Falle eines normalen Multirate-Bandpaß-Filters keine Rolle, da hier die Abtastrate von Ein- und Ausgang gleich ist. Das bedeutet, daß jeder Dezimator einen entsprechenden Interpolator als Gegenstück besitzt. Der Wechsel der Abtastrate durch Dezimator/Interpolation ist damit für das Gerüst aus I-Q-Mischer und Zurückmischer gleichsam nicht sichtbar.

Dagegen erfordert die Verarbeitung komplexer Signale, wie z.B. das Digital Beam Forming für Phased Array-Antennen, die Kenntnis von I- und Q-Komponenten zur gleichen Zeit. Die Erfordernisse das erfindungsgemäße Verfahren sind ähnlich: Hier werden am Ausgang des Prozessors die Samples $i_o$, $q_2$, $-i_4$, $-q_6$ ... erzeugt, während im Prozessor intern die gleichzeitigen Samples beider Kanäle benötigt werden.

Die Erzeugung der versetzten I- und Q-Kanal-Abtastwerte (Samples) läßt im Prinzip zwei grundsätzliche Realisierungen zur Durchführung des erfindungsgemäßen Verfahrens zu:

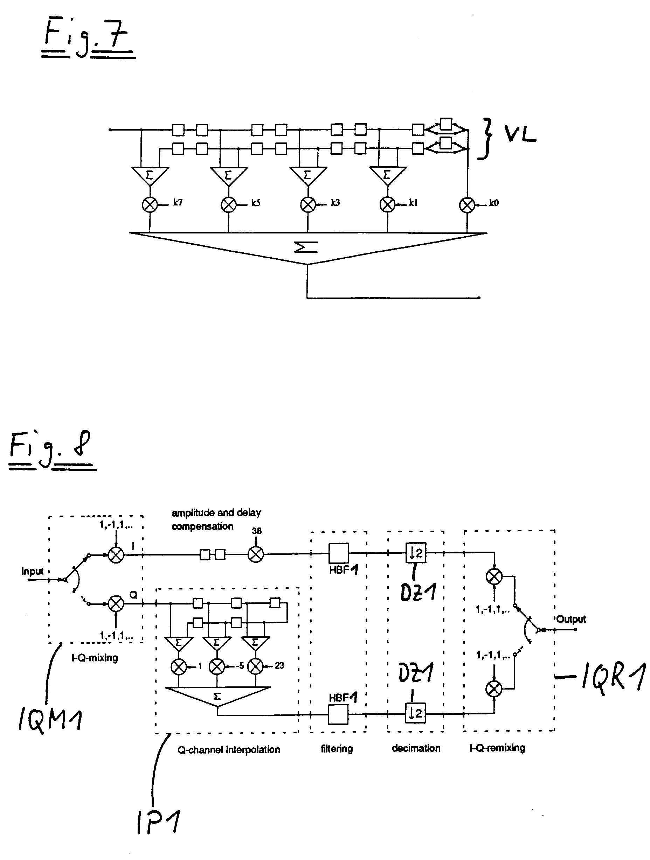

- Der Q-Kanal-Interpolator aus Fig. 4 kann mit dem Tiefpaß des Q-Kanal-Zweiges verschmolzen werden. Alternativ können I- und Q-Kanal so verzögert werden, daß sich in beiden Zweigen eine um einen Abtasttakt unterschiedliche Gruppenlaufzeit ergibt. Der resultierende Prozessorkern ist in Fig. 8 dargestellt. Doppelte Laufzeitglieder führen hier zu einer Dekomposition von I- und Q-Kanal, das heißt die Samples der einzelnen Kanäle liegen immer abwechselnd, nie aber zusammen, an den Multiplizierern der Filterstruktur an. Da sich beide Kanäle nur in ihren Koeffizienten, nicht aber in ihrer Struktur unterscheiden, können beide Kanäle im selben Rechenwerk verarbeitet werden, indem man nach jedem Takt auf den entsprechenden Koeffizientensatz umschaltet. Wenn man eine genügende Anzahl verschiedener Koeffizientensätze vorsieht, können auch die Multiplizierer der I-Q-Mischstufen in den Prozessor gezogen werden. Im Beispielprozessor aus Fig. 5 sind in der Mitte der Verzögerungsleitung VL zwei Laufzeitglieder GS schaltbar gestaltet. Dadurch ist es möglich, den Prozessor in ein Standard-Halbband-Filter umzuschalten. Dieser, im folgenden als Typ I bezeichnete Prozessor ist daher optimal für einen Einsatz als Universalfilterstufe geeignet. Fig. 6 zeigt das Prinzipschaltbild eines Vorrichtung, welche einen Prozessorkern vom Typ I umfaßt. Sie arbeitet auf die versetzten Abtastwerte von I- und Q-Kanal in einem einzigen Pfad.

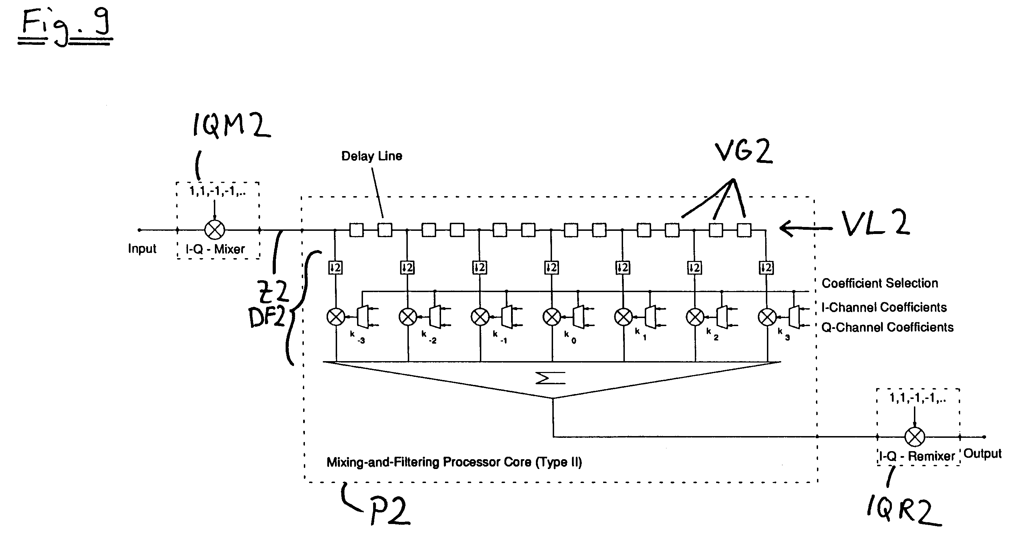

- Dagegen zeigt Fig. 7 einen Prozessor zur Durchführung des erfindungsgemäßen Verfahrens, der eine externe Q-Kanal-Interpolation erfordert. Auch hier dient eine Verzögerungsleitung VL aus doppelten Verzögerungselementen zur Dekomposition von I- und Q-Kanal, ebenso kann das Filter durch zwei schaltbare Verzögerungsglieder zu einem konventionellen Halbband-Filter umkonfiguriert werden. Dieser im folgenden als Typ II bezeichnete Prozessor setzt jedoch im Gegensatz zu Typ I eine symmetrische Pulsantwort voraus. Die Symmetrie wird ausgenutzt, um den Rechenaufwand, konkret die Anzahl der aufwendigen Multiplikationen, zu minimieren. Die Senkung des Rechenaufwandes liegt bei typischen Filtern in der Größenordnung von 45 Prozent, da die Multiplikationen den Rechenaufwand dominieren. Die Beschränkung auf symmetrische Impulsantworten verhindert allerdings, daß die Interpolationsstufe in das Filter gezogen werden kann, da die Interpolation immer im unsymmetrischen Impulsantworten verbunden ist.

In allen Fällen kann auch die Dezimation mit Gewinn in den Prozessorkern gezogen werden. Dabei werden Dezimationselemente so zwischen die Verzögerungsleitung und die gedächtnislosen arithmetischen Elemente angeordnet, daß nur die wirklich benötigten Samples des Ausgangssignales berechnet werden. Damit wird der Prozessor nur mit der Ausgangssamplingrate und nicht mit der höheren Eingangssamplingrate betrieben.

Im folgenden werden drei verschiedene Möglichkeiten zur Implementierung des erfindungsgemäßen Verfahrens ausführlich beschrieben.

Fig. 8 zeigt die direkte Übertragung des erfindungsgemäßen Verfahrens in ein Rechenwerk. I- und Q-Kanal werden durch einen I-Q-Mischer **IQM1** gewonnen und als separate Datenströme zum nachfolgenden Q-Kanal-Interpolator **IP1** geleitet. Der Q-Kanal-Interpolator **IP1** berechnet die zum I-Kanal zeitgleichen Abtastwerte des Q-Kanals. Diese Aufgabe übernimmt hier ein einzelner Interpolator. In einer vorteilhaften Ausbildung, hier jedoch nicht dargestellt, kann diese Aufgabe auch ein Digital Product Detector übernehmen, der aus Pellon, L.: A Double Nyquist Digital Product Detector for Quadrature Sampling IEEE Trans. Sig. Proc., Vol. 40, July 1992, p 1672 bekannt ist. Die zeitgleich aufeinander abgeglichenen Abtastwerte aus I- und Q-Kanal werden danach mit Hilfe zweier Halbband-Filter **HBF1** gefiltert. Dabei wird auch die Abtastrate in den einzelnen Zweigen halbiert. Anschließend erfolgt in beiden Kanälen die Dezimation in einem Dezimator **DZ1**. In einer vorteilhaften Ausführung kann die Dezimation aus Gründen des Rechenaufwandes in das Halbbandfilter **HBF1** integriert werden. Auf Filter **HBF1** und Dezimator **DZ1** folgt schließlich der I-Q-Rückmischer **IQR1**. In dieser Baugruppe werden die beiden Teilsignale zum Ausgangssignal zusammengefügt.

Der spezielle Vorteil der direkten Implementierung liegt darin, daß die Halbband-Filter **HBF1** mit nur einem Viertel der Abtastrate des Eingangssignals arbeiten müssen. Dafür ist aber der Einsatz insgesamt zweier Halbband-Filter erforderlich.

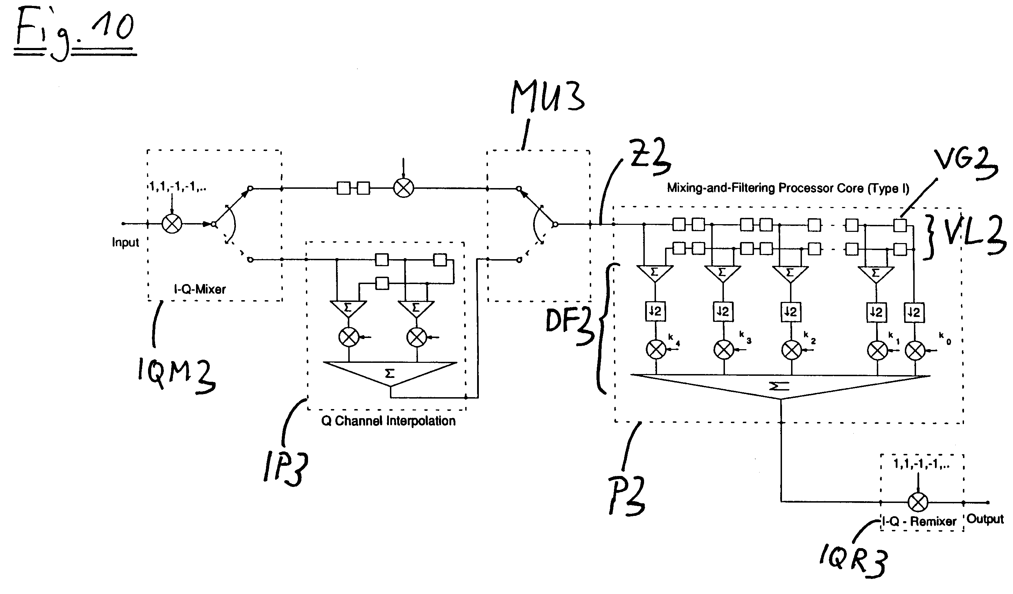

Fig. 9 zeigt die Implementierung des erfindungsgemäßen Verfahrens mit einem Prozessor **P2** vom Typ I (siehe Fig. 5). Er zeichnet sich dadurch aus, daß er auf zeitversetzt vom I-Q-Mischer **IQM2** gewonnenen Abtastwerten arbeitet. Die vom I-Q-Mischer **IQM2** gewonnenen Abtastwerte für den I- und Q-Kanal werden in einem gemeinsamen Zweig **Z2** geführt, der die Abtastwerte von I- und Q-Kanal in eine Verzögerungsleitung **VL2** mit doppelten Verzögerungsgliedern **VG2** leitet. Damit werden I- und Q-Kanal getrennt. Der Prozessor **P2** umfaßt neben der Verzögerungsleitung **VL2** auch ein dezimierendes Filter **DF2**, indem sowohl die Dezimation als auch die Filterung durchgeführt wird. Das dezimierende Filter **DF2** weist zwischen I- und Q-Kanal umschaltbare Koeffizienten ..., $k_{-3}$, $k_{-2}$, $k_{-1}$, $k_o$, $k_{+1}$, $k_{+2}$,... zur zeitversetzten Verarbeitung der beiden Kanäle auf.

Im Prozessor P wird sowohl die Interpolation von I- und Q-Kanal nach Art eines Digital Product Detectors, wie auch die Filterung und Dezimation von I- und Q-Kanal vorgenommen. Anschließend erfolgt an einem I-Q-Rückmischer **IQR2** die Gewinnung des Ausgangssignals. In der dargestellten Ausführung sind I-Q-Mischer und I-Q-Rückmischer **IQM2**, **IQR2** in der Form eines schaltbaren Inverters ausgebildet. Anstatt zwei Multiplizierern wie bei einem herkömmlichen I-Q-Mischer ist hierbei nur noch ein Multiplizierer vorhanden, der ausschließlich die Faktoren +1,-1 aufweist.

Die Interpolation in dem Prozessor **P2** führt zu unsymmetrischen Impulsantworten. Daher ist dieser Prozessor nicht mehr als Halbbandfilter anzusehen. Die fehlende Symmetrie führt im Vergleich zum Prozessor-Typ II (siehe Fig. 7) zu einem höheren Rechenaufwand für das Filter. Dagegen entfällt der separate Interpolator. Bei der praktischen Anwendung muß daher sorgfältig geprüft werden, welcher Prozessor-Typ die günstigere Alternative darstellt. Nachteilig an dem Prozessor-Typ I ist die Tatsache, daß die Filterkoeffizienten ..., $k_{-3}$, $k_{-2}$, $k_{-1}$, $k_o$, $k_{+1}$, $k_{+2}$,...nach jedem Takt umgeschaltet werden müssen, da sich die Koeffizienten von I- und Q-Kanal sich von einander unterscheiden.

In Fig. 10 ist eine Implementierung des erfindungsgemäßen Verfahrens mit einem Prozessor P vom Typ II (Siehe Fig. 7) dargestellt. Diese Vorrichtung entspricht weitgehend derjenigen aus Fig. 8. In beiden Fällen ist eine separate Q-Kanal-Interpolation vorgesehen. Beim hier abgebildeten Prozessor **P3** werden die Daten jedoch zeitversetzt in einem Filter verarbeitet. Das führt dazu, daß im Interpolator **IP3** und im Prozessor **P3** Multiplikationen mit derselben Frequenz berechnet werden.

Im einzelnen ist die Vorrichtung folgendermaßen aufgebaut:

Mit einem I-Q-Mixer **IQM3** sowie einem nachgeschalteten Q-Kanal-Interpolator **IP3** werden zeitgleiche Abtastwerte von I- und Q-Kanal erzeugt. Mit einem Multiplexer **MU3** werden die Abtastwerte von I- und Q-Kanal zeitversetzt in eine gemeinsame Verzögerungsleitung **VL3** mit doppelten Verzögerungsgliedern **VG3** eingespeist. Diese Verzögerungsleitung dient zur Trennung der nunmehr zeitversetzten Abtastwerte von I- und Q-Kanal. Anschließend erfolgt in einem dezimierenden Filter **DF3** die zeitversetzte Dezimation und Filterung von I- und Q-Kanal. Das dezimierende Filter **DF3** ist hier derart aufgebaut, daß es zu symmetrischen Pulsantworten führt. Bei einer solchen symmetrische Impulsantwort sind die Koeffizienten $k_o$, $k_1$, $k_2$, k3,... des Filters paarweise gleich, so daß die Hälfte der Multiplikationen dadurch eingespart werden können.

Abschließend erfolgt am I-Q-Rückmischer **IQR3** die Gewinnung des Ausgangsignals.

Wie bei der Vorrichtung nach Fig. 8 kann zur Erzeugung der zeitgleichen Abtastwerte von I- und Q-Kanal anstatt des I-Q-Mischers **IQM3** mit nachgeschaltetem Interpolator **IP3** auch ein Digital Product Detector eingesetzt werden.

**Patentansprüche**

1. Verfahren zur Filterung von Bandpaß-Signalen mit einer Mittenfrequenz von etwa einem Viertel der Abtastrate, **gekennzeichnet durch** folgende Verfahrensschritte:

   - I-Q-Mischen des Eingangssignals mit ca. einem Viertel der Abtastrate des Eingangssignals
   - Filterung und Dezimation jeweils im I- und Q-Kanal um einen Faktor n, wobei n= 2, 3, 4, ....... ist
   - I-Q-Rückmischen zur Gewinnung des Ausgangssignals mit einer Abtastrate, welche halb so groß ist wie die dezimierte Abtastrate im I- und Q- Kanal.

2. Vorrichtung zur Durchführung des Verfahrens nach Anspruch 1, umfassend:

   - eine Vorrichtung (IQM1, IP1) zur Gewinnung von zeitgleichen Abtastwerten von I- und Q-Kanal
   - eine Vorrichtung (HBF1, DZ1) zur Filterung und Dezimation jeweils im I- und Q-Kanal
   - einem I-Q-Rückmischer (IQR1) zur Gewinnung des Ausgangssignals.

3. Vorrichtung nach Anspruch 2, **dadurch gekennzeichnet,** daß die Vorrichtung zur Gewinnung von zeitgleichen Abtastwerten von I- und Q-Kanal ein I-Q-Mischer (IQM1) mit nachgeschaltetem Interpolator (IP1) ist.

4. Vorrichtung nach Anspruch 2, **dadurch gekennzeichnet,** daß die Vorrichtung zur Gewinnung von zeitgleichen Abtastwerten von I- und Q-Kanal ein Digital Product Detector ist.

5. Vorrichtung nach einem der Ansprüche 2 bis 4, **dadurch gekennzeichnet,** daß die Vorrichtung (HBF1, DZ1) zur Filterung und Dezimation ein Halbbandfilter ist.

6. Vorrichtung zur Durchführung des Verfahrens nach Anspruch 1, umfassend:

   - einen I-Q-Mischer (IQM2) zur Gewinnung von zeitversetzten Abtastwerten von I- und Q-Kanal, wobei I- und Q-Kanal in einem gemeinsamen Zweig (Z2) geführt werden
   - eine Verzögerungsleitung (VL2) aus doppelten Verzögerungsgliedern (VG2) zur Trennung der zeitversetzten Abtastwerte von I- und Q-Kanal
   - ein dezimierendes Filter (DF2) zur zeitversetzten Dezimation und Filterung von I- und Q-Kanal

- einen I-Q-Rückmischer (IQR2) zur Gewinnung des Ausgangssignals.

7. Vorrichtung nach Anspruch 6, **dadurch gekennzeichnet,** daß der I-Q-Mischer (IQM2) ein schaltbarer Inverter ist, der anstatt zwei Multiplizierern nur noch ein Multiplizierer mit den Faktoren +1, -1 aufweist.

8. Vorrichtung nach einem der Ansprüche 6 bis 7, **dadurch gekennzeichnet,** daß das dezimierende Filter (DF2) schaltbare Koeffizienten zur zeitversetzten Verarbeitung von I- und Q-Kanal besitzt.

9. Vorrichtung zur Durchführung des Verfahrens nach Anspruch 1, mit:

    - einer Vorrichtung (IQM3, IP3) zur Gewinnung von zeitgleichen Abtastwerten von I- und Q-Kanal
    - einem Multiplexer (MU3), mit dem I- und Q-Kanal zeitversetzt in einen gemeinsamen Zweig (Z3) eingespeist werden
    - einer Verzögerungsleitung (VL3) aus doppelten Verzögerungsgliedern (VG3) zur Trennung der zeitversetzten Abtastwerte von I- und Q-Kanal
    - einem dezimierenden Filter (DZ3) mit symmetrischer Pulsantwort zur zeitversetzten Dezimation und Filterung von I- und Q-Kanal
    - einem I-Q-Rückmischer (IQR3) zur Gewinnung des Ausgangssignals.

10. Vorrichtung nach Anspruch 9, **dadurch gekennzeichnet,** daß die Vorrichtung zur Gewinnung von zeitgleichen Abtastwerten von I- und Q-Kanal ein I-Q-Mischer (IQM3) mit nachgeschaltetem Interpolator (IP3) ist.

11. Vorrichtung nach Anspruch 9, **dadurch gekennzeichnet,** daß die Vorrichtung zur Gewinnung von zeitgleichen Abtastwerten von I- und Q-Kanal ein Digital Product Detector ist.

# Fig. 1

(a)

I-Q - Mixing

(b1)

(b2)

Decimation

(c1)

(c2)

I-Q - Remixing

(d)

Fig.2

1, 0, -1, 0, . . .

1, 0, -1, 0, . . .

LP  ↓2

LP  ↓2

0, 1, 0, -1, . . .

0, 1, 0, -1, . . .

I-Q-Mischen

I-Q-Zurückmischen

Fig.3

1,0,-1,0,..

I

i0, 0, i2, 0, i4 ...

Input

x0, x1, x2, x3, x4 ...

Q

0, q1, 0, q3, 0 ...

0,1,0,-1,..

Fig.4

1, 0, -1, 0, . . .

I - Arm

1, 0, -1, 0, . . .

Delay Compen- sation

LP  ↓2

Interpolator 1 Sample Delay

LP  ↓2

0, 1, 0, -1, . . .

Q - Arm

0, 1, 0, -1, . . .

I-Q-Mixer

HBF/ Dezimator

I-Q-Remixer

Fig.5

Fig.6

Fig. 7

Fig. 8

# Fig. 9

IQM2

Delay Line

VG2

1,1,-1,-1,..

Input

I-Q - Mixer

VL2

Z2
DF2

↓2  ↓2  ↓2  ↓2  ↓2  ↓2  ↓2

Coefficient Selection

I-Channel Coefficients

Q-Channel Coefficients

$k_{-3}$  $k_{-2}$  $k_{-1}$  $k_0$  $k_1$  $k_2$  $k_3$

$\Sigma$

1,1,-1,-1,..

Mixing-and-Filtering Processor Core (Type II)

I-Q - Remixer   Output

P2

IQR2

EP 0 717 494 A2

# Fig. 10